# FASCICULE DE BREVET EUROPEEN

(11) **EP 3 409 084 B1**
(45) Date de publication et mention de la délivrance du brevet: **08.09.2021**
(21) Numéro de dépôt: 17706586.9
(22) Date de dépôt: 27.01.2017
(51) Int. Cl.: H05K 7/14, H02G 3/02

(54) **PLATINE DE CONNEXION DE HARNAIS ELECTRIQUES**
KABELBAUMANSCHLUSSPLATTE
WIRING HARNESS CONNECTION PLATE

(30) Priorité: 28.01.2016 FR 1650702
(43) Date de publication de la demande: 05.12.2018
(73) Titulaire: Safran Electrical & Power, 31702 Blagnac Cedex (FR)
(72) Inventeur: TCHAAOUAOU, Ismaïl, 31702 Blagnac Cedex (FR); COLIN, Frédéric, 31830 Plaisance du Touch (FR)
(74) Mandataire: Ernest Gutmann - Yves Plasseraud S.A.S.
(86) Numéro de dépôt international: PCT/FR2017/050199
(87) Numéro de publication internationale: WO 2017/129925

(56) Documents cités:
- FR-A1- 2 998 442
- US-A- 5 342 203

## Description

La présente invention concerne une platine électrique pour la connexion de deux harnais électriques entre eux dans un avion en particulier.

Pour faciliter leur fabrication, les avions sont construits en tronçons aboutés les uns aux autres que l'on transporte vers un site d'assemblage.

Chaque tronçon comprend une partie structurelle, un habillage et un circuit de transmission aussi bien fluidique qu'énergétique comme un circuit électrique. Le circuit électrique comprend différents harnais électriques, chacun pourvu de plusieurs câbles électriques.

Lors de l'assemblage de deux tronçons ensembles, les harnais électriques d'un premier tronçon doivent être connectés aux harnais électriques d'un second tronçon. Pour cela il est connu d'utiliser soit un rack de connexion comprenant une plaque métallique servant de support à chacun des harnais et permettant la connexion des deux harnais entre eux, soit des borniers électriques pourvus de goujons sur lesquels sont montées des cosses solidaires des harnais.

Les normes de sécurité imposent qu'au droit du raccordement de deux harnais entre eux, une protection contre l'écoulement d'eau soit prévue, de sorte à empêcher l'écoulement d'eau sur la connexion entre les deux harnais. Une protection connue se présente sous la forme d'une tôle rapportée, soudée ou boulonnée sur la plaque métallique servant de support aux harnais.

Une autre norme impose que les plaques de connexion prévoient des espaces de connexion supplémentaires pour la connexion de harnais supplémentaires, par exemple pour répondre à l'ajout d'un harnais non prévu initialement.

US 5342203 divulgue une platine électrique pour la connexion de harnais électrique.

Plus encore FR 2998442 divulgue une platine électrique pour la connexion entre eux de deux harnais électriques, ladite platine comprenant un porte-modules et au moins un module connecteur pour permettre la connexion entre les deux harnais électriques, le module connecteur comprenant une base engagée avec le porte-modules, une âme ajourée prolongeant la base et permettant la connexion des deux harnais entre eux via des fiches.

Une telle installation permet de connecter deux harnais entre eux tout en respectant les différentes normes existantes. Toutefois elle présente certains inconvénients.

Premièrement l'utilisation d'un matériau métallique alourdit l'avion au détriment de sa consommation de carburant. Cet alourdissement n'est en outre pas compensé par les espaces supplémentaires disponibles créés car ceux-ci ne peuvent en fait pas être utilisés étant donné qu'ils doivent rester disponibles pour la connexion éventuelle de harnais supplémentires.

Deuxièmement, la mise en place de la tôle de protection s'avère particulièrement difficile étant donné l'espace restreint dans lequel les opérateurs de montage peuvent utiliser leurs outils. La mise en place de la tôle est notamment difficile lorsque la tôle est rapportée soudée sur la plaque métallique.

Enfin, chaque platine est typiquement de conception différente en fonction du nombre maximal de harnais à connecter. Ainsi, il arrive de reconcevoir une platine parce qu'un nombre trop petit d'emplacements de connexion a été prévu par rapport au nombre de harnais à connecter.

L'invention a notamment pour but d'apporter une solution simple, efficace et économique à ce problème.

A cet effet, l'invention propose, en premier lieu, une platine électrique pour la connexion entre eux de deux harnais électriques, ladite platine comprenant un porte-modules et au moins un module connecteur pour permettre la connexion entre les deux harnais électriques. Le module connecteur comprend une base engagée avec le porte-modules, une âme ajourée prolongeant la base et permettant la connexion des deux harnais entre eux via des fiches, caractérisée en ce que le porte-module comprend :
- un mors fixe ;
- un mors mobile monté pivotant sur le mors fixe entre une position de fermeture dans laquelle le mors mobile est contre le mors fixe et une position d'ouverture dans laquelle le mors mobile est écarté du mors fixe, et
- des moyens de verrouillage pour maintenir le mors mobile en position de fermeture, et
le mors fixe comprend une rainure allongée pouvant recevoir longitudinalement, par engagement amovible, la base de plusieurs modules connecteur disposés côte à côte, le mors mobile s'étendant le long de ladite rainure en position de fermeture pour y bloquer alors le(s) module(s) reçu(s) là.

Ladite rainure peut s'étendre selon un axe qui est l'axe de pivotement du mors mobile par rapport au mors fixe.

En outre, le module connecteur pourra comprendre un parapluie recouvrant l'âme, pour protéger de projections d'eau la connexion de deux harnais électriques. Avantageusement, le parapluie est opposé à la base et sensiblement perpendiculaire à l'âme du module connecteur.

Une telle platine offre un gain de masse puisque les modules connecteurs sont ajoutés sur le porte-modules en fonction du nombre de harnais à connecter. Ainsi, la platine est évolutive en fonction du besoin, des modules peuvent être ajoutés ou supprimés afin que la platine comprenne autant de modules connecteurs qu'il y a de connexions à réaliser.

Avantageusement, l'âme du module connecteur comprend au moins deux trous de fixation pour une fixation des fiches d'un harnais à l'autre, d'une part, et avec le module connecteur, d'autre part, par exemple au moyen d'au moins un dispositif de liaisons.

Bien entendu, le nombre de trous de l'âme sera réalisé en fonction du nombre de points de fixation des fiches, une fiche pouvant comprendre un nombre de points de fixation supérieur à deux, par exemple trois, quatre ou plus encore. De plus, les systèmes vis/écrou peuvent être remplacés par des moyens de clipsage qui offrent l'avantage d'être utilisables sans avoir recours à des outils tels que des clés ou des tourvenis.

Les harnais sont alors solidarisés entre eux pour permettre la transmission de signaux électriques d'un harnais vers l'autre, mais également au module connecteur de sorte que les harnais soient immobiles par rapport à l'avion.

Selon un mode de réalisation, la platine comprend également au moins un module de ségrégation comprenant une base, une âme pleine et un parapluie et/ou au moins un module d'obturation comprenant une base et un rebord prolongeant la base.

Les modules de ségrégation assurent une barrière physique entre deux harnais adjacents de sorte à éviter les interférences entre lesdits deux harnais ou pour matérialiser la séparation entre deux circuits distincts.

Les modules d'obturation sont montés sur le porte-modules de sorte à éviter que le porte module ne s'encrasse mais aussi de sorte à pouvoir être remplacés par des modules connecteurs ou des modules de ségrégation, si nécessaire.

Avantageusement, les parapluies de chaque module connecteur et/ou module de ségrégation comprennent un premier côté de plus grande longueur présentant une surépaisseur et un second côté de plus grande longueur, opposé au premier, en forme de cavité ouverte apte à recevoir la surépaisseur d'un module connecteur ou de ségrégation adjacent.

Les parapluies de deux modules connecteurs et/ou de ségrégation sont alors emboités l'un dans l'autre de sorte à réaliser une étanchéité entre les modules, visant à protéger les harnais de toute projection d'eau.

De préférence, la base des modules comprend un corps et un pion faisant saillie du corps.

Cette architecture particulière permet de loger les différents modules dans le porte-module de manière sûre et de sorte que ceux-ci aient un degré de liberté très limité voire quasi-nul.

En outre, le porte-module peut comprendre un cadre sur lequel est monté le mors fixe lorsque le mors fixe ne peut pas être monté directement sur la structure de l'avion. Le cadre peut également être prévu pour recevoir plusieurs mors fixes.

De préférence, la rainure est sensiblement en forme de L, intégrant ainsi une fente de réception du corps prolongée par un logement transversal de réception du pion, le pion de chaque base venant se loger dans le logement de la rainure quand la rainure reçoit plusieurs modules côte à côte.

Ainsi, les modules sont parfaitement maintenus sur le porte-module créant ainsi un ensemble robuste.

Selon un mode de réalisation préféré, les modules et le porte-module sont réalisés dans un matériau thermoplastique visant à limiter la masse de la platine.

L'invention propose, en second lieu, un ensemble comprenant :
- deux harnais électriques qui comprennent chacun une fiche pour la connexion des deux harnais entre eux ;
- une platine de connexion du type précité, et
- au moins un système vis/écrou pour la fixation des fiches des deux harnais entre elles.

Un tel ensemble permet de réaliser une connexion rapide et sûre de deux tronçons, et plus particulièrement la connexion énergétique de deux tronçons lors de l'assemblage entre eux de deux tronçons d'un avion.

L'invention sera si nécessaire mieux comprise et d'autres détails, caractéristiques et avantages de l'invention pouvant apparaître à la lecture de la description suivante faite à titre d'exemple non limitatif en référence aux dessins annexés dans lesquels :
- la figure 1 est une vue en perspective d'une platine pour la connexion de deux harnais électriques entre eux ;
- la figure 2 est une vue en perspective d'un porte-modules de la platine de la figure 1 ;
- la figure 3 est une vue schématique montrant une rainure en L du porte-modules pour permettre la fixation des modules ;
- la figure 4 est une vue en perspective d'un module connecteur de la platine de la figure 1 ;
- la figure 5 est une vue en perspective d'un module de ségrégation de la platine de la figure 1 ;
- la figure 6 est une vue en perspective d'un module d'obturation de la platine de la figure 1 ;
- la figure 7 est une vue de face montrant la connexion entre eux de plusieurs modules connecteurs et/ou modules de ségrégation, et
- la figure 8 est une vue en perspective montrant un platine électrique sur laquelle viennent se raccorder deux circuits distincts comportant chacun plusieurs harnais électriques.

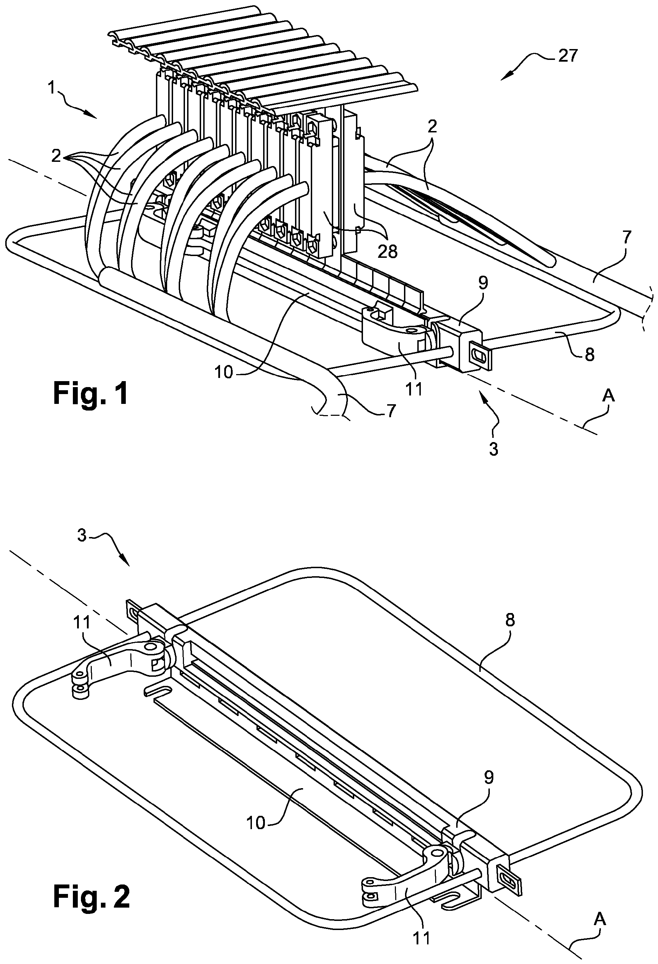

On a représenté, sur la figure 1, une platine 1 électrique permettant la connexion entre eux d'au moins deux harnais 2 électriques.

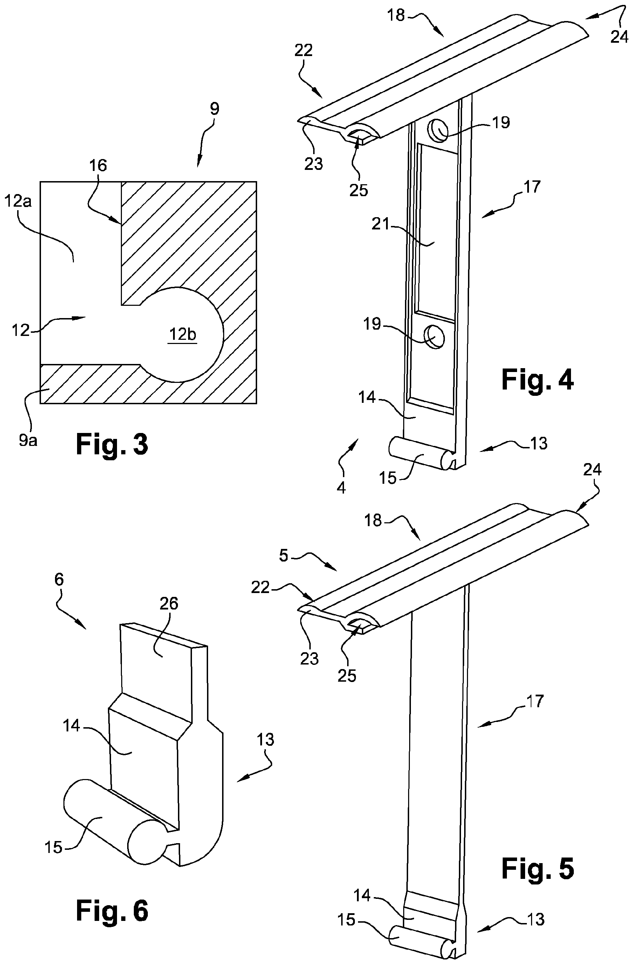

La platine 1 comprend un porte-modules 3, représenté sur la figure 2, et différents modules 4, 5, 6 aptes à être montés sur le porte-modules 3, à savoir un module 4 connecteur, un module 5 de ségrégation et un module 6 d'obturation respectivement, représentés sur les figures 3 à 5.

Les platines 1 électriques sont généralement utilisées aux extrémités des tronçons d'un avion pour permettre le raccordement et la continuité des circuits de transmission énergétique, notamment des circuits 7 électriques.

En référence à la figure 2, le porte-modules 3 comprend :
- un mors 9 fixe monté sur le cadre 8 ;
- un mors 10 mobile monté pivotant sur le mors 9 fixe, autour d'un axe A, entre une position de fermeture dans laquelle le mors 10 mobile est contre le mors 9 fixe et une position d'ouverture dans laquelle le mors 10 mobile est écarté du mors 9 fixe ;
- des moyens 11 de verrouillage pour maintenir le mors 10 mobile en position de fermeture, et éventuellement
- un cadre 8 sur lequel est monté le mors 9 fixe.

Le cadre 8, se présentant sous la forme d'une structure en fil formant une interface entre la structure de l'avion et le mors 9 fixe, peut être utilisé par exemple lorsque le mors 9 fixe ne peut pas être fixé avec un élément de la structure de l'avion. Le cadre 8 permet sert alors d'interface pour la fixation d'un ou plusieurs mors 9 fixe(s) sur la structure.

En l'espèce, les moyens 11 de verrouillage sont des cames. Toutefois, d'autres moyens permettant de maintenir le mors 10 mobile en position de fermeture pourraient être utilisés.

La figure 3 montre de manière schématique, une rainure 12 sensiblement en L pratiquée dans le mors 9 fixe, cette rainure 12 étant apte à recevoir les différents modules 4, 5, 6 comme détaillé ci-après.

La platine 1 comprend trois types de modules 4, 5, 6 différents, à savoir un module 4 connecteur, représenté sur la figure 4, un module 5 de ségrégation, représenté sur la figure 5, et un module 6 d'obturation représenté sur la figure 6.

Les trois types de modules 4, 5, 6 ont en commun une base 13 venant s'engager dans le porte-modules 3 et se différencient par une partie du module qui prolonge la base 13.

La base 13 des modules comprend un corps 14 et un pion 15 faisant saillie du corps 14, le pion 15 venant se loger dans la portion de plus petite longueur de la rainure 12 en L et le corps 14 venant en appui contre une surface 16 verticale délimitant la portion de plus petite longueur du L.

Afin de permettre la fixation par enclipsage des modules 4, 5, 6 avec le mors 9 fixe, la partie de plus petite longueur du L est de forme complémentaire au pion 15. Ainsi, par déformation élastique d'une portion 9a inférieure du mors 9 fixe, le pion 15 est maintenu dans la rainure 12 en L. Il en résulte une facilité de montage et de démontage des modules 4, 5, 6 sur le mors 9 fixe ce qui facilite le travail des opérateurs au bénéfice de la modularité de la platine 1.

Comme on le voit sur les figures, le corps 14 est sensiblement parallélépipédique et le pion 15 a une forme sensiblement ovale. Toutefois, d'autres formes particulières sont possibles.

L'on décrit à présent les parties propres à chacun des modules 4, 5, 6.

Le module 4 connecteur comprend une âme 17 ajourée, prolongeant la base 13 et permettant la connexion de deux harnais 2 entre eux, et un parapluie 18 sensiblement perpendiculaire à l'âme 17 et opposé à la base 13. Le parapluie 18 permet de protéger l'âme 17, et notamment la connexion entre deux harnais, de gouttes d'eau ou de gouttes de condensation provenant d'éléments situés au-dessus des harnais 2.

Avantageusement, l'âme 17 ajourée du module 4 connecteur comprend au moins deux trous 19 de fixation pour permettre la fixation des harnais 2 entre eux, d'une part, et avec le module 4 connecteur, d'autre part, par exemple au moyen de liaisons 20 vis/écrou.

En outre, l'âme 17 des modules connecteurs comprend une fenêtre 21 permettant de réaliser la connexion électrique des deux harnais 2 entre eux.

Les modules 5 de ségrégation sont similaires aux modules 4 connecteurs, à la différence près que leur âme 17 est dépourvue de trous 19 de fixation et de fenêtre 21. Ainsi, l'âme 17 des modules 5 de ségrégation est pleine au lieu d'être ajourée comme l'âme 17 des modules 4 connecteurs.

Le parapluie 18 de chaque module 4 connecteur et module 5 de ségrégation comprend un premier côté 22 de plus grande longueur présentant une surépaisseur 23 et un second côté 24 de plus grande longueur, opposé au premier, en forme 25 de cavité ouverte apte à recevoir la surépaisseur 23 d'un module 4 connecteur ou d'un module 5 de ségrégation adjacent.

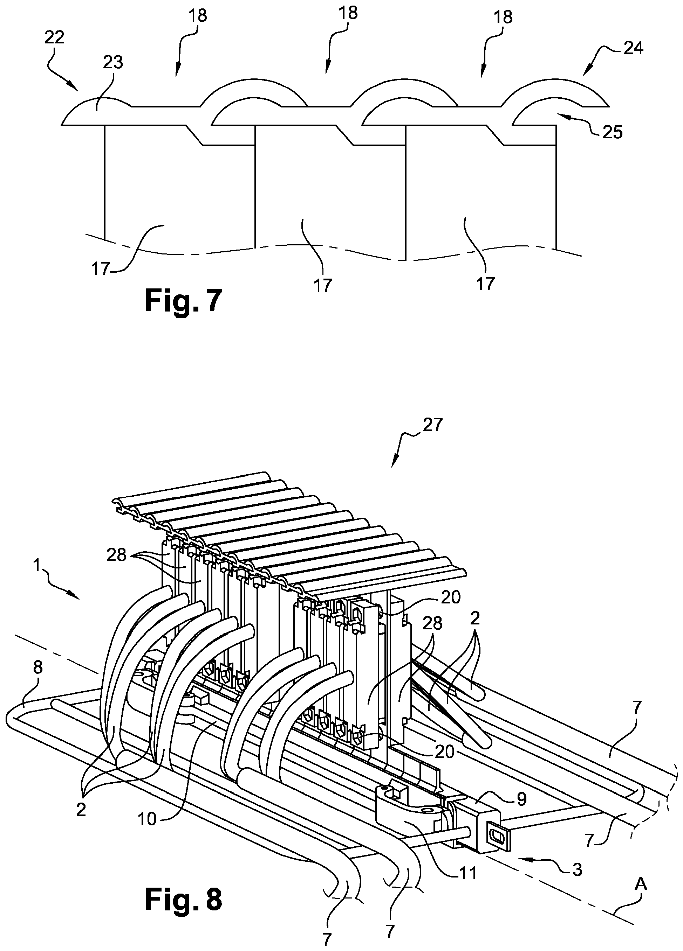

La figure 7 montre l'interaction entre les parapluies 18 de plusieurs modules 4 connecteurs ou modules 5 de ségrégation adjacents. Ainsi, si l'eau arrive sur le dessus des parapluies 18 elle ne pourra pas traverser les parapluies 18 par défaut d'ouverture permettant son passage, l'eau ruissellera alors sur les parapluies 18 de sorte que les connexions entre deux harnais 2 soient protégées.

Enfin, les modules 6 d'obturation comprennent un simple rebord 26 prolongeant la base 13 sensiblement selon la direction d'extension de la base 13.

Chacun de ces modules 4, 5, 6 a un rôle particulier. Les modules 4 connecteurs permettent la connexion entre deux harnais 2 tandis que les modules 5 de ségrégation permettent la séparation entre deux harnais 2 adjacents d'un même circuit 7 ou de deux circuits 7 distincts. Enfin, les modules 6 d'obturation assurent une fonction de remplissage destinée à empêcher que la rainure 12 en L du mors 9 fixe du porte-module 3 ne s'encrasse.

Selon un mode de réalisation avantageux, le porte-modules 3 et les modules 4, 5, 6 sont réalisés dans un matériau thermoplastique offrant un bon compromis entre résistance mécanique et légèreté.

Sur la figure 8, on a représenté un ensemble 27 comprenant :
- deux harnais 2 électriques qui comprennent chacun une fiche 28 pour la connexion des deux harnais 2 entre eux ;
- une platine 1 de connexion telle que précédemment décrite, et
- au moins un dispositif 20 de liaison pour la fixation des fiches 28 des deux harnais 2 entre elles.

Avantageusement, le dispositif 20 de liaison est un système vis/écrou 20 mais il pourrait s'agir de pattes clipsables dans une fiche 28 opposée et/ou dans les modules 4 connecteurs.

Plus précisément, deux circuits 7 électriques sont raccordés sur la platine 1, les deux circuits 7 étant séparés l'un de l'autre par un module 5 de ségrégation.

On remarque que, dans cet ensemble 27, tous les types de modules 4, 5, 6 sont montés sur le porte-modules 3. Chacun des modules 6 d'obturation pourront, le cas échéant, être remplacés par un module 4 connecteur ou un module 5 d'obturation de sorte à augmenter les possibilités de connexion des harnais 2.

Les dispositifs 20 permettent, au travers des trous 19 de fixation des modules 4 connecteurs, la fixation des fiches 28 des harnais 2 entre elles, mais également la fixation de chacun des harnais 2 sur le module 4 connecteur par serrage de chacune des fiches 28 sur les modules 4 connecteurs.

La platine 1 qui vient d'être décrite offre une grande modularité pour la connexion de deux harnais 2 entre eux, mais également une bonne sécurité de fixation puisque chacun des harnais 2 peut être séparé des autres par un module 5 de ségrégation, notamment pour éviter les interférences entre les harnais 2.

De plus, l'utilisation de modules 4, 5, 6 engageables entre les deux mors 9, 10 du porte-modules 3 facilite les opérations de connexion ou de déconnexion de harnais 2 puisque les modules 4, 5, 6 sont interchangeables et qu'une connexion temporaire pour une réparation ou pour l'ajout d'un nouveau circuit 7 est possible de manière simple et rapide.

Enfin, l'utilisation d'un matériau thermoplastique permet d'une part de limiter la masse de la platine 1 mais également de mieux maîtriser les tolérances de fabrication de ses éléments constitutifs, de telle sorte que l'assemblage de différents modules 4, 5, 6 sur le porte-module 3 garantisse une bonne protection des harnais 2.

## Revendications

1. Platine (1) électrique pour la connexion entre eux de deux harnais (2) électriques, ladite platine (1) comprenant un porte-modules (3) et au moins un module (4) connecteur pour permettre la connexion entre les deux harnais (2) électriques, le module (4) connecteur comprenant une base (13), engagée avec le porte-modules (3), une âme (17) ajourée prolongeant la base (13) et permettant la connexion des deux harnais (2) entre eux via des fiches (28), **caractérisée en ce que** le porte-modules (3) comprend :
- un mors (9) fixe ;
- un mors (10) mobile monté pivotant sur le mors (9) fixe entre une position de fermeture dans laquelle le mors (10) mobile est contre le mors (9) fixe et une position d'ouverture dans laquelle le mors (10) mobile est écarté du mors (9), et
- des moyens (11) de verrouillage pour maintenir le mors (10) mobile en position de fermeture, et
le mors (9) fixe comprend une rainure (12) allongée pouvant recevoir longitudinalement, par engagement amovible, la base de plusieurs modules (4) connecteur disposés côte à côte, le mors (10) mobile s'étendant le long de ladite rainure en position de fermeture pour y bloquer alors le(s) module(s) reçu(s) là.

2. Platine (1) selon la revendication 1, **caractérisée en ce que** le module (4) connecteur comprend un parapluie (18) recouvrant l'âme (17), pour protéger la connexion de deux harnais (2) électriques.

3. Platine (1) selon la revendication 1 ou 2, **caractérisée en ce que** l'âme (17) du module (4) connecteur comprend au moins deux trous (19) de fixation pour permettre la fixation des fiches (28) de chaque harnais (2) entre elles, d'une part, et avec le module (4) connecteur, d'autre part, par exemple au moyen d'au moins un dispositif (20) de liaison.

4. Platine (1) selon l'une quelconque des revendications précédentes, **caractérisée en ce qu'**elle comprend également au moins un module (5) de ségrégation comprenant une base (13), une âme (17) pleine et un parapluie (18) et/ou au moins un module (6) d'obturation comprenant une base (13) et un rebord (26) prolongeant la base (13).

5. Platine (1) selon la revendication 2 et la revendication 4, **caractérisée en ce que** les parapluies (18) de chaque module (4) connecteur et module (5) de ségrégation comprennent un premier côté (22) de plus grande longueur présentant une surépaisseur (23) et un second côté (24) de plus grande longueur, opposé au premier, en forme (25) de cavité ouverte apte à recevoir la surépaisseur (23) d'un module (4) connecteur ou d'un module (5) de ségrégation adjacent.

6. Platine (1) selon l'une quelconque des revendications précédentes **caractérisée en ce que** la base (13) d'un module comprend un corps (14) et un pion (15) faisant saillie du corps (14).

7. Platine (1) selon l'une quelconque des revendications précédentes, **caractérisée en ce que** le porte-module (3) comprend également un cadre (8) sur lequel est monté le mors (9) fixe.

8. Platine (1) selon les revendications 1 et 6, **caractérisée en ce que** la rainure (12) est sensiblement en forme de L, intégrant ainsi une fente (12a) de réception du corps (14) prolongée par un logement (12b) transversal de réception du pion (15), le pion (15) de chaque base (13) venant se loger dans le logement (12b) de la rainure (12) quand la rainure reçoit plusieurs modules (4, 5, 6) côte à côte.

9. Ensemble (27) comprenant :
- deux harnais (2) électriques qui comprennent chacun une fiche (28) pour la connexion des deux harnais (2) entre eux ;
- une platine (1) de connexion selon l'une quelconque des revendications précédentes, et
- au moins un dispositif (20) de liaison pour la fixation des fiches (28) des deux harnais (2) entre elles.

## Patentansprüche

1. Elektrische Platine (1) zum Verbinden von zwei elektrischen Kabelbäumen (2) miteinander, wobei die Platine (1) einen Modulträger (3) und zumindest ein Verbindermodul (4) enthält, um die Verbindung zwischen den beiden elektrischen Kabelbäumen (2) zu ermöglichen, wobei das Verbindermodul (4) einen Sockel (13), der mit dem Modulträger (3) in Eingriff steht, und einen perforierten Kern (17) enthält, der den Sockel (13) fortsetzt und die Verbindung der beiden Kabelbäume (2) miteinander über Stecker (28) ermöglicht,
**dadurch gekennzeichnet, dass** der Modulträger (3) enthält:
- eine ortsfeste Backe (9);
- eine bewegliche Backe (10), die zwischen einer Schließposition, in der die bewegliche Backe (10) an der ortsfesten Backe (9) anliegt, und einer Offenposition, in der die bewegliche Backe (10) von der Backe (9) wegbewegt ist, schwenkbar an der ortsfesten Backe (9) angebracht ist, und
- Verriegelungsmittel (11), um die bewegliche Backe (10) in Schließposition zu halten, und
dass die ortsfeste Backe (9) eine längliche Nut (12) aufweist, die durch lösbaren Eingriff den Sockel von mehreren nebeneinander angeordneten Verbindermodulen (4) in Längsrichtung aufnehmen kann, wobei sich die bewegliche Backe (10) in Schließposition entlang der Nut erstreckt, um dann das oder die darin aufgenommenen Module darin zu sichern.

2. Platine (1) nach Anspruch 1,
**dadurch gekennzeichnet, dass** das Verbindermodul (4) eine Abschirmung (18) aufweist, die den Kern (17) abdeckt, um die Verbindung zweier elektrischer Kabelbäume (2) abzuschirmen.

3. Platine (1) nach Anspruch 1 oder 2,
**dadurch gekennzeichnet, dass** der Kern (17) des Verbindermoduls (4) zumindest zwei Befestigungslöcher (19) aufweist, um die Befestigung der Stecker (28) jedes Kabelbaums (2) einerseits untereinander und andererseits am Verbindermodul (4) zu gestatten, beispielsweise mittels zumindest einer Verbindungsvorrichtung (20).

4. Platine (1) nach einem der vorhergehenden Ansprüche,
**dadurch gekennzeichnet, dass** sie ferner zumindest ein Trennmodul (5) mit einem Sockel (13), einem massiven Kern (17) und einer Abschirmung (18) und/oder zumindest ein Verschlussmodul (6) mit einem Sockel (13) und einem den Sockel (13) fortsetzenden Steg (26) enthält.

5. Platine (1) nach Anspruch 2 und Anspruch 4,
**dadurch gekennzeichnet, dass** die Abschirmungen (18) jedes Verbindermoduls (4) und jedes Trennmoduls (5) eine erste Seite (22) mit größerer Länge, die eine Überdicke (23) aufweist, und eine zweite Seite (24) mit größerer Länge, die der ersten gegenüberliegt, in Form eines offenen Hohlraums (25) aufweisen, der die Überdicke (23) eines benachbarten Verbindermoduls (4) oder Trennmoduls (5) aufnehmen kann.

6. Platine (1) nach einem der vorhergehenden Ansprüche,
**dadurch gekennzeichnet, dass** der Sockel (13) eines Moduls einen Körper (14) und einen aus dem Körper (14) herausragenden Zapfen (15) enthält.

7. Platine (1) nach einem der vorhergehenden Ansprüche,
**dadurch gekennzeichnet, dass** der Modulträger (3) auch einen Rahmen (8) aufweist, an dem die feste Backe (9) angebracht ist.

8. Platine (1) nach den Ansprüchen 1 und 6,
**dadurch gekennzeichnet, dass** die Nut (12) im Wesentlichen L-förmig ist und somit einen Schlitz (12a) zur Aufnahme des Körpers (14) aufweist, der von einer quer verlaufenden Aufnahme (12b) zur Aufnahme des Zapfens (15) fortgesetzt wird, wobei der Zapfen (15) jedes Sockels (13) in der Aufnahme (12b) der Nut (12) dann aufgenommen wird, wenn die Nut mehrere Module (4, 5, 6) nebeneinander aufnimmt.

9. Anordnung (27), enthaltend:
- zwei elektrische Kabelbäume (2), die jeweils einen Stecker (28) zur Verbindung der beiden Kabelbäume (2) miteinander aufweisen;
- eine Verbindungsplatine (1) nach einem der vorhergehenden Ansprüche, und
- zumindest eine Verbindungsvorrichtung (20) zur Befestigung der Stecker (28) der beiden Kabelbäume aneinander.

## Claims

1. Electrical board (1) for connecting two electrical harnesses (2) to each other, wherein said board (1) comprises a module holder (3) and at least one connector module (4) to establish the connection between the two electrical harnesses (2), said connector module (4) comprising a base (13) engaged with the module holder (3), a perforated core (17) extending the base (13) and allowing connection of the two harnesses (2) to each other via plugs (28), **characterised in that** the module holder (3) comprises:
- a fixed jaw (9);
- a movable jaw (10) mounted to pivot on the fixed jaw (9) between a closed position in which the movable jaw (10) is against the fixed jaw (9) and an open position in which the movable jaw (10) is spaced apart from the jaw (9), and
- locking means (11) for holding the mobile jaw (10) in the closed position, and,
the fixed jaw (9) comprises an elongated groove (12) capable of longitudinally receiving, by a detachable engagement, the base of several connector modules (4) arranged side by side, the movable jaw (10) extending along said groove in the closed position to then block there the module(s) received therein.

2. Board (1) according to claim 1, **characterised in that** the connector module (4) comprises a cover (18) covering the core (17) to protect the connection of two electrical harnesses (2).

3. Board (1) according to any of claims 1 or 2, **characterised in that** the core (17) of the connector module (4) comprises at least two attachment holes (19) for fixing the plugs (28) of each harness (2) to the other on the one hand and to the connector module (4) on the other hand, for example by means of at least one linking device (20).

4. Board (1) according to any one of the preceding claims, **characterised in that** it also comprises at least one segregation module (5) comprising a base (13), a solid core (17) and an cover (18) and/or at least one filler module (6) comprising a base (13) and a flange (26) extending the base (13).

5. Board (1) according to claim 2 and claim 4, **characterised in that** the covers (18) of each connector module (4) and segregation module (5) comprise a first longer side (22) with an excess thickness (23) and a second longer side (24), opposite the first, in the form of an open cavity (25) capable of receiving the excess thickness (23) of an adjacent connector module (4) or segregation module (5).

6. Board (1) according to any one of the preceding claims, **characterised in that** the base (13) of a module comprises a body (14) and a pin (15) protruding from the body (14).

7. Board (1) according to any one of the preceding claims, **characterised in that** the module holder (3) also comprises a frame (8) on which the fixed jaw (9) is mounted.

8. Board (1) according to claims 1 and 6, **characterised in that** the groove (12) is substantially L-shaped, thereby integrating a slot (12a) for receiving the body (14) elongated by a transverse recess (12b) for receiving the pin (15), said pin (15) of each base (13) being accommodated in the recess (12b) of the groove (12) when the groove receives several modules (4, 5, 6) side by side.

9. Assembly (27) comprising:
- two electrical harnesses (2), each comprising a plug (28) for connection of the two harnesses (2) to each other;
- the connection board (1) according to any one of the preceding claims and
- at least one linking device (20) for fixing the plugs (28) of the two harnesses (2) together.
